# EUROPEAN PATENT APPLICATION

(11) **EP 2 705 892 A1**
(43) Date of publication of application: **12.03.2014**
(21) Application number: 13158275.1
(22) Date of filing: 08.03.2013
(51) Int. Cl.: B01D 53/00, H01L 31/032, C23C 14/58

(54) **Gas recovering system for recovering Dihydrogen Selenide from an exhaust gas of a process for obtaining CIGS thin film layers**

(30) Priority: 20.07.2012 TW 101126402
(71) Applicant: Kern Energy Enterprise Co., Ltd., Taipei City 110 (TW); Sakamoto, Hitoshi, Kanagawa-ken 238-0311 (JP)
(72) Inventor: Sakamoto, Hitoshi, kanagawa-ken, 238-0311 (JP); Ying-Shih, Hsiao, 110 Taipei City (TW)
(74) Representative: Lang, Christian

(57) **Abstract**

The invention related gas recovering system contains at least one gas supply system, a gas treatment system, and a gas separation system. The gas supply system includes a gas supply unit and a supply source. The gas treatment system includes a gas reactor and a gas reduction device. Also, the gas separation system includes a first exhaust unit, a purifying unit, a second exhaust unit and a heating evaporation unit. The gas recovering system can avoid the unnecessary waste of gas to form hazardous waste. Therefore, gas can make more effective use to reduce cost.

## Description

### BACKGROUND OF THE INVENTION

### 1. Field of the Invention

The present invention is related to a gas recovering system, and more particularly, to a gas recovering system to recover exhaust gas generated by thermally decomposing Dihydrogen Selenide.

### 2. Description of the Prior Art

Copper Indium Gallium Selenide (CIGS) thin film optoelectronic device is high efficiency solar cell. The solar substrate made by CIGS is required to go through selenization process except evaporation process. The current selenization process implements Dihydrogen Selenide (H₂Se) to be reactant gas in business.

For example, when a CIGS solar cell is required to do selenization process, the multi-layer precursor or an alloy with copper, gallium and indium is formed on the glass substrate by sputtering technique and transmits to selenization furnace (a thermal furnace). The Dihydrogen Selenide (H₂Se) gas is entered to the selenization furnace. When the temperature of the selenization furnace is over 400°C, Dihydrogen Selenide (H₂Se) gas is reacted with the multi-layer precursor film. However, during the selenization process of the CIGS solar cell, the solar cell structure with multi-layer film stacking is required to be heated, and the solar cell can be well reacted with Dihydrogen Selenide (H₂Se) gas so as to obtain good CIGS thin film layer. Because of the selenization within the selenization furnace, it is required to maintain an enough concentration of the Dihydrogen Selenide completely reacted with multi-layer precursor thin film. The extra and non-reacted gas is treated by the eliminating system and is not reused.

The selenium used in the common selenization process is obtained by solid state selenium or gaseous state selenium, but most thereof is gaseous state selenium. The gaseous state selenium includes corrosiveness and toxicity, and the gaseous state selenium is generated by reacting furnace pyrolysis for selenization. In order to provide enough concentration of selenium atoms, the addition consumption and the cost of the waste treatment is increased.

### SUMMARY OF THE INVENTION

In order to solve the problems described above, one object of the present invention is to provide a gas recovering system to recover the heat cracked Dihydrogen Selenide by a high efficiency gas recovering method.

According objects above, a gas recovering system in the present invention includes at least one gas supply source, a gas reduction device and a gas separation system. The at least one gas supply source includes a supply source configured to provide at least one gas, and a gas supply unit connected to the supply source. The at least one gas treatment system is connected to the gas supply system and includes a gas reactor connected to the gas supply unit and a gas reduction device connected to the gas reactor. The gas separation system is connected to the gas treatment system and includes a first exhaust unit connected to the gas reduction device; a purifying unit connected to the first exhaust unit; a second exhaust unit connected to the connected to the purifying unit; and a heating evaporation unit connected to the purifying unit and the gas supply system.

Another object of the present invention is to provide a gas recovering device to recover the exhaust gas to reduce the cost so as to increase the usage efficiency.

According objects above, a gas recovering device in the present invention includes a gas reduction unit and a gas guiding tube. A first gas is flowed within the gas guiding tube and the gas reduction unit is connected to the gas guiding tube. The gas reduction unit includes a conduit, a reduction gas source and a microwave irradiating device. The conduit is connected to the gas guiding tube. The reduction gas source is connected to the conduit and is configured to provide a second gas flowed to the gas guiding tube. The microwave irradiating device is configured to irradiate a microwave and the microwave is irradiated to the second gas of the conduit.

According objects above, a gas recovering system in the present invention comprising: at least one gas supply system, at least one gas treatment system connected to the gas supply system and a gas separation system connected to the gas treatment system. The gas supply system including: a supply source configured to provide at least one gas; and a gas supply unit connected to the supply source. The gas treatment system including: a gas reactor connected to the gas supply unit; and a gas reduction device connected to the gas reactor, and the gas reduction device including a gas reduction unit and a gas guiding tube, and the gas reduction unit is connected to the gas guiding tube. The gas separation including: a first exhaust unit connected to the gas reduction device; a purifying unit connected to the first exhaust unit; a second exhaust unit connected to the purifying unit; and a heating evaporation unit connected to the purifying unit and the gas supply system.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein:
FIG. 1 is a functional block diagram illustrating a simplifying process procedure of a gas recovering system in the present invention.
FIG. 2 is a functional block diagram illustrating the process procedure of the gas recovering system in the present invention.
FIG. 3 is a view illustrating the gas recovering device in the present invention.
FIG. 4 is a view illustrating the gas recovering device in another embodiment of the present invention.
FIG. 5 is the gas recovering system in another embodiment of the present invention.
FIG. 6 is the gas recovering system in one another embodiment of the present invention.

### DESCRIPTION OF THE PREFERRED EMBODIMENT

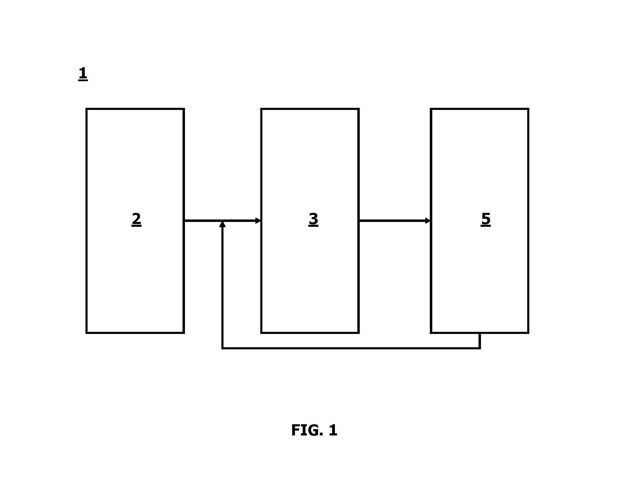

Now please refer to FIG. 1, which is a functional block diagram illustrating a simplifying process procedure of a gas recovering system in the present invention. As shown in FIG. 1, the gas recovering system 1 includes three parts, which are a gas supply system 2, a gas treatment system 3 and a gas separation system 5. The gas supply system 2 is configured to supply gas (such as Dihydrogen Selenide) and the gas vents into many devices and reactors in the gas treatment system 3 to selenization. The used Dihydrogen Selenide gas is passing through the operation units of the gas separation system 5 to recovery in the gas treatment system 3.

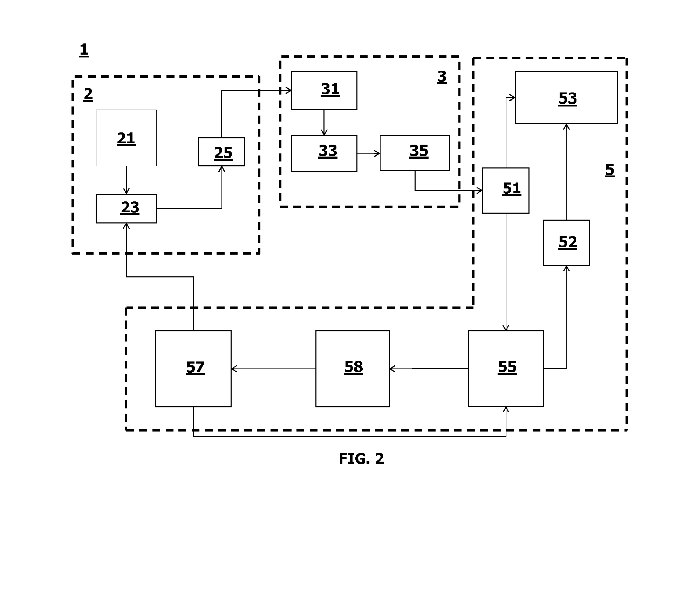

Now please refer to FIG. 2, which is a functional block diagram illustrating the process procedure of the gas recovering system in the present invention. As shown in FIG. 2, the gas supply system 2 includes a supply source 21 and a gas supply unit 23. The supply source 21 is configured to supply gas, such as Dihydrogen Selenide. The gas is stored in the steel cylinder or a high pressure gas vessel. Dihydrogen Selenide is used as a sample in the present invention, but the supply source 21 can also provide different gas, such as oxygen, Dihydrogen and other carrier gas used to dilute the concentration of the Dihydrogen Selenide gas.

The supply source 21 configured to store Dihydrogen Selenide is connected to the gas supply unit 23. When the vapor within the steel cylinder of the supply source 21 reaches a balance and a high pressure status is in the steel cylinder, the Dihydrogen Selenide in the cylinder is liquid and the valve is opened to provide continuous vapor heat source. The liquid state Dihydrogen Selenide will continually evaporate to be gaseous state Dihydrogen Selenide. The supply source 21 is connected to the gas supply unit 23 by a transportation pipe. The gas supply unit 23 can adjust the gas transmitted from the supply source 21 and is configured to work with the mass flow controller 25 to control the flow of the gas. The mass flow controller 25 includes an automatic gas flow control function and will not be affected by the change of the system temperature and the pressure to maintain a certain flow rate. So the mass flow controller 25 is a flow control device and is connected to the gas treatment system 3.

The gas treatment system 3 includes a gas reactor 31 and a gas reduction device 35. Before the Dihydrogen Selenide gas is transmitted to the gas reactor 31, the Dihydrogen Selenide gas is mixed with gas, such as Nitrogen or Argon gas, to enter the gas reactor 31. The proper concentration of the mix gas can maintain the even property of the quality and distribution of the Dihydrogen Selenide in the gas reactor 31.

When the CIGS layer within the solar cell is required to do a Selenization process, a multi-layer precursor monomer or an alloy with copper, gallium and indium stacked as a cell structure is formed on a Soda Lime Glass substrate and transmitted to the gas reactor 31 and the Dihydrogen Selenide gas is transmitted to the gas reactor 31. Now, the temperature of the gas reactor 31 is above 400°C, the multi-layer precursor with copper, gallium and indium will be reacted well with the Dihydrogen Selenide gas so as to obtain a good CIGS thin film layer. The following equation is a heat cracking equation of the Selenization:

H₂Se→HSe⁻+H⁺

H₂Se→2H⁺+Se²⁻

When the Dihydrogen Selenide is completely heat cracked, Se²⁻ and 2H⁺ are generated. Se²⁻ will compose with the multi-layer precursor monomer or the alloy with copper, gallium and indium and 2H⁺ will be vented as exhaust gas. In addition, if the Hdrogen Selenide is not completely heat cracked, it would generate HSe⁻ and H⁺ and both of them will be vented as exhaust gas.

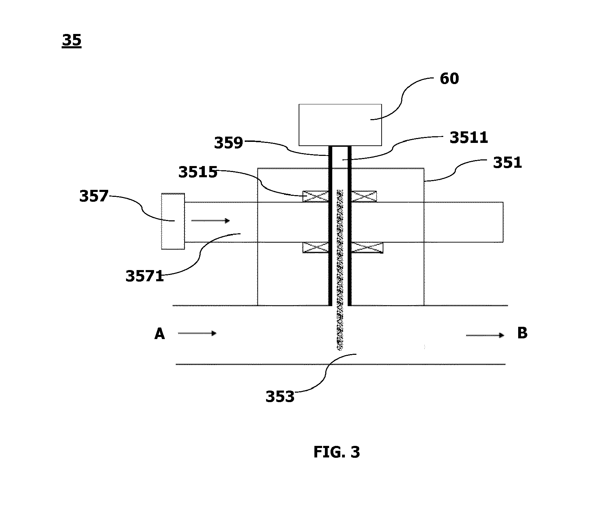

The Dihydrogen Selenide gas is heat cracked to form HSe⁻ gas and is transmitted to the first storage vessels 33 by the transportation pipe. The temperature of the transportation pipe is maintained in 160°C to provide the ionized Dihydrogen Selenide gas. Because it is required a predetermined time to connect the first storage vessel 33 with the gas reduction device 35, it is necessary to have the first storage vessel to delay the gas process. Now, the gas reduction device 35 will provide enough H⁺ to compose the waste gas HSe⁻ from the first storage vessel to form H₂Se so as to recover. The detail description of the steps will be described in FIG. 3.

Now, the H₂Se gas processed by the gas reduction device 35 will transmit to the gas separation system 5. The gas separation system 5 includes a first exhaust unit 51 and a purifying unit 55, a second gas venting unit 52 and a heat evaporating unit 57. The H₂Se gas is transmitted to the first exhaust unit 51 first. The first exhaust unit 51 includes a compressor for gas absorbing and depressing and transmits the H₂Se gas to the purifying unit 55 to purify the concentration of the Dihydrogen Selenide gas. The waste gas, which is not qualified to vent, is processed by the eliminating device 53 and the detail description thereof is described at the following.

The Dihydrogen Selenide gas is transmitted from the first exhaust unit 51 to the purifying unit 55. The purifying unit 55 includes a cooling device (not shown) and the temperature thereof is set at range of -40°C ∼-80°C. When the Dihydrogen Selenide gas is passing the cooling device, the gaseous state Dihydrogen Selenide is liquefied to be liquid because the melting point of Dihydrogen Selenide is -65.73°C. The liquid state Dihydrogen Seledine is separated from other gas, which is not liquefied. Now, the liquid state Dihydrogen Selenide is transmitted to the second storage vessel 58 and the rest gas is processed by the second exhaust unit 52. Because the heating vapor unit 57 processing the liquid state Dihydrogen Selenide to be the gaseous state Dihydrogen Selenide is required a certain time, the second storage vessel 58 is necessary to delay the process. The heating vapor unit 57 includes a heater (not shown) and the heater can provide a stable heat source to heat the liquid state Dihydrogen Selenide. The temperature of the heating vapor unit 57 is set to over -41.25°C, the liquid state Dihydrogen Selenide is gasified to be the gaseous state Dihydrogen Selenide. The heater can provide enough heat for evaporating the liquid state Dihydrogen Selenide. Now, the gaseous state Dihydrogen Selenide is transmitted to the gas supply unit 23 to provide recovering. The recovering rate of the Dihydrogen Selenide is above 50%, and the recovering efficiency is pretty good.

In addition, the Seledium used in the present system is poisonous, it is required to process properly to put at outside. Therefore, it is necessary to develop a toxic waste handling device. The first exhaust unit 51 and the second gas venting unit 52 in the previous description are connected to a hazardous waste eliminating device 53. The hazardous waste eliminating device 53 includes some materials, such as copper hydroxide (Cu(OH)₂) or Calcium hydroxide (Ca(OH)₂) to absorb the Selenium elements so as to react with the Selenium to be Copper Selenide CuSe or Calcium Selenide CaSe, and the rest unhazardous waste gas can be safely released.

In addition, when the gas recovering system 1 is required to do a system maintain or temporally stop to provide the recovering Dihydrogen Selenide to stop the whole system reaction, The liquid state Dihydrogen Selenide stored in the second storage vessel 58 will be heated by the heat evaporate unit 57 to be the gaseous state Dihydrogen Selenide. The purifying unit 55 will stop the operation of the cooling device and the liquid state Dihydrogen Selenide is transmitted to the hazardous waste handling device 53 from the second exhaust unit 52 to process the non-recovering Dihydrogen Selenide gas.

The transportation pipe in each system unit of the present invention is stainless steel material covered with heat insulation cover. The thermal conductivity property of the heat insulation cover is low to reduce the heat transmitted from the transportation pipe to outside, but the material of the transportation pipe is not limited herein. Now please refer to FIG. 3, which is a view illustrating the gas recovering device in the present invention. As shown in FIG. 3, the gas recovering device 35 includes a gas recovering unit 351 and a gas conduit 353. The gas recovering unit 351 is connected to the gas conduit 353 and the gas conduit is disposed at bottom of the gas conduit 353.

The gas conduit in the present description is the transportation pipe in the previous description. The transmitting gas is Oxygen or Argon gas and hazardous waste gas with HSe⁻. The flowing direction of the hazardous waste gas is from A end to B end, as shown in FIG. 3. The gas recovering unit 351 includes a conduit 3511 connected to the gas conduit 353, a recovering gas source 60 connected to the gas conduit 353 and a microwave transmitting device 357 transmitting a microwave to the conduit 3511. The present invention includes a transmitting pipe 3571 to transmit the microwave. The conduit 3511 is passing through the transmitting pipe 3571 and is configured to transmit oxygen. The microwave transmitting device 357 will transmit the microwave from the transmitting pipe 3571 to Dihydrogen within the conduit 3511 to generate plasma and uses Electron Cyclotron Resonance (ECR) to increase the density of the plasma. The ion source is by the microwave transmitted from the microwave transmitting device 357 and the frequency of the microwave is above 800 MHz. The oxygen transmitted from the transmitting pipe 3571 to the venting pip 3511 to react with the Dihydrogen ions within the conduit 3511 to form H⁺. It should be noted that the material of the conduit 3511 in the present embodiment is metal material but the material of the conduit 3511 in the present invention is not limited herein. The pipe wall within the conduit 3511 further includes a dielectric layer material 359, such as Al₂O₃ and the dielectric layer material 359 can help the microwave emitted to the conduit 3511.

In addition, the external wall of the transmitting pipe 3571 includes a plurality of first magnetic field coil 3515 and the magnetic field generated thereof will let cyclotron frequency and microwave frequency with coherence to generate harmony so as to generate high energy electrons to hit the gas within the conduit 3511. The previous Dihydrogen Selenide is heat cracked in the gas reactor 31 to form HSe⁻ gas. When the gas is transmitted from the gas conduit 353 (transportation pipe) to the gas recovering device 35, the recovering gas source 600 will inject the Dihydrogen to the conduit 3511. The microwave transmitting device 357 will transmit microwave, and the transmitting pipe 3571 will ionize the Dihydrogen within the conduit 3511 to form H⁺. The magnetic coil in the external wall of the transmitting pipe 3571 will guild H⁺ to move to the bottom of the gas conduit 353 and should avoid hitting the pipe wall during the moving process. The pressure of the ionized H in the conduit 3511 is larger than the gas conduit 353, so H will from high pressure to low pressure transmit in the conduit 3511. The HSe⁻ flowing in the gas conduit 353 will react with H to form (H₂Se) and the (H₂Se) can use the gas recovering system. The equation to form (H₂Se) is:

HSe⁻+H⁺→H₂Se

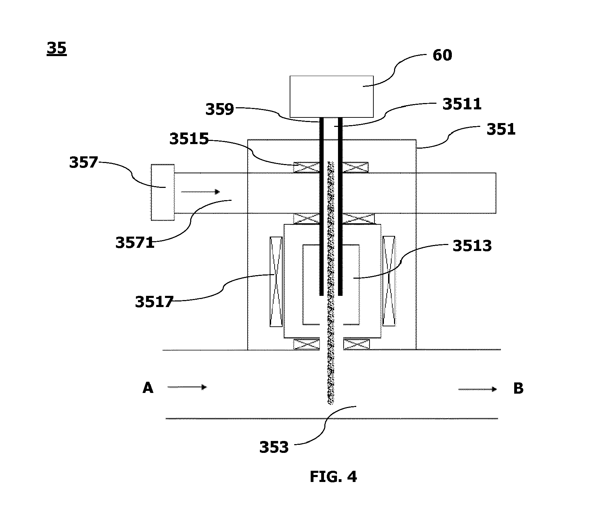

In addition, please refer to FIG. 4, which is a view illustrating the gas recovering device in another embodiment of the present invention. As shown in FIG. 4, the conduit 3511 and the gas conduit 353 will includes a chamber 3513 therebetween and a plurality of second magnetic field coils will disposed around the chamber 3513. In the installation of the present embodiment, the density of H⁺ transmitted from the conduit 3511 is enhanced to avoid expansion and H⁺ hitting to each other to form Dihydrogen.

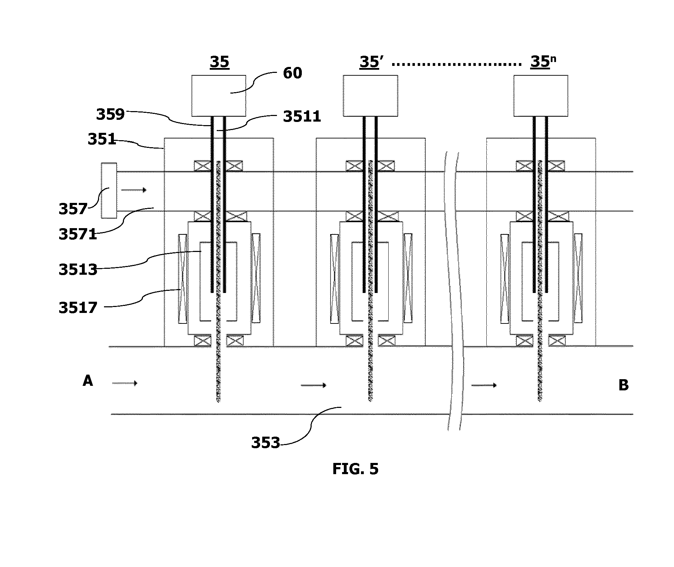

Now, please refer to FIG. 5, which is the gas recovering system in another embodiment of the present invention. As shown in FIG. 5, the gas recovering system 1 includes a plurality of gas recovering devices 35, 35' ... 35n and the recovering gas ability is fast because of the gas recovering devices 35, 35' ...35n. The gas recovering system 1 can take care a lot of HSe⁻ to recover to be Dihydrogen Selenide with a better processing efficiency. The operation procedure in each of the gas recovering devices 35 is the same as in FIG. 3 and FIG. 4, and the detail description thereof is omitted herein.

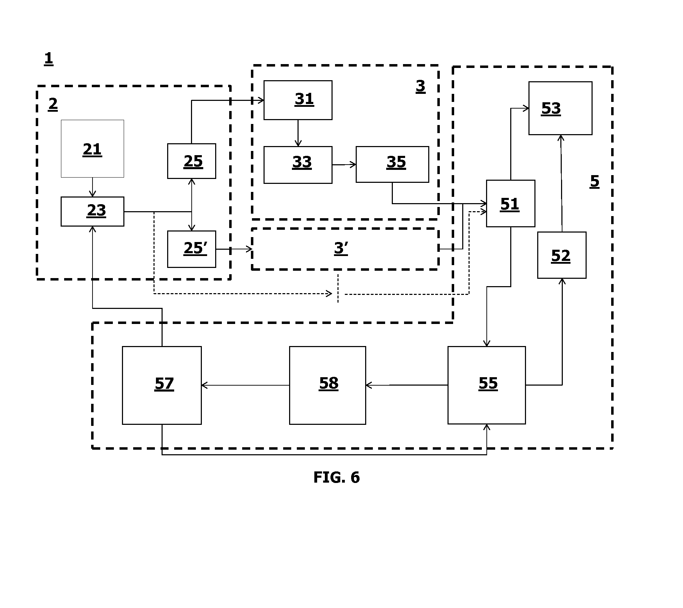

Now please refer to FIG. 6, which is the gas recovering system in one another embodiment of the present invention. As shown in FIG. 6, the gas recovering system 1 include a plurality of gas processing systems 3, 3' ..., and each of the gas processing systems 3, 3' ...(represent by dash line) includes one of mass flow controllers 5, 25'... (represent by dash line) so as to process many CIGS solar cell to do the Selenization process to reduce the manufacturing time. The design and function in rest of the components and each of the gas processing system 3 is the same as the previous description and the detail description thereof is omitted herein.

## Claims

1. A gas recovering system, comprising:
at least one gas supply system including:
a supply source configured to provide at least one gas;
a gas supply unit connected to the supply source;
at least one gas treatment system connected to the gas supply system and including:
a gas reactor connected to the gas supply unit; and
a gas reduction device connected to the gas reactor;
a gas separation system connected to the gas treatment system and including:
a first exhaust unit connected to the gas reduction device;
a purifying unit connected to the first exhaust unit;
a second exhaust unit connected to the purifying unit; and
a heating evaporation unit connected to the purifying unit and the gas supply system.

2. The gas recovering system of claim 1, wherein the gas supply system further includes an eliminating device connected to the first exhaust unit and the second exhaust unit.

3. The gas recovering system of claim 1, wherein the gas treatment system further includes a first storage vessel and the first storage vessel is connected to the gas reactor and the gas reduction device.

4. The gas recovering system of claim 1, wherein the gas separation device further includes a second accumulator tank, and the second accumulator tank is connected to the purifying unit and the heating evaporation unit.

5. A gas recovering device including a gas reduction unit and a gas guiding tube, and a first gas is flowed within the gas guiding tube and the gas reduction unit is connected to the gas guiding tube, wherein the gas reduction unit is **characterized by**: the gas reduction unit including:
a conduit connected to the gas guiding tube;
a reduction gas source connected to the conduit and is configured to provide a second gas flowed to the gas guiding tube; and
a microwave irradiating device configured to irradiate a microwave and the microwave is irradiated to the second gas of the conduit.

6. The gas recovering device of claim 5, wherein microwave irradiating device further includes an irradiating tube and a conduit of the gas reduction unit is vertically passing through the irradiating tube.

7. The gas recovering device of claim 5, wherein a chamber is further disposed between the conduit and the gas guiding tube.

8. A gas recovering system, comprising:
at least one gas supply system including:
a supply source configured to provide at least one gas; and
a gas supply unit connected to the supply source;
at least one gas treatment system connected to the gas supply system and including: and
a gas reactor connected to the gas supply unit; and
a gas reduction device connected to the gas reactor, and the gas reduction device including a gas reduction unit and a gas guiding tube, and the gas reduction unit is connected to the gas guiding tube;
a gas separation system connected to the gas treatment system and including:
a first exhaust unit connected to the gas reduction device;
a purifying unit connected to the first exhaust unit;
a second exhaust unit connected to the purifying unit; and
a heating evaporation unit connected to the purifying unit and the gas supply system.

9. The gas recovering system of claim 8, wherein the gas reduction unit including:
a conduit connected to the gas guiding tube;
a reduction gas source connected to the conduit and is configured to provide a second gas flowed to the gas guiding tube; and
a microwave irradiating device configured to irradiate a microwave and the microwave is irradiated to the second gas of the conduit.

10. The gas recovering system of claim 8, wherein the gas treatment system further includes a first storage vessel and the first storage vessel is connected to the gas reactor and the gas reduction device.
